# EUROPEAN PATENT SPECIFICATION

(11) **EP 2 345 051 B1**
(45) Date of publication and mention of the grant of the patent: **22.08.2018**
(21) Application number: 09778807.9
(22) Date of filing: 02.10.2009
(51) Int. Cl.: H01G 9/20

(54) **A METHOD OF MANUFACTURING A PHOTOVOLTAIC DEVICE, AN INTERMEDIATE MANUFACTURING PRODUCT AND A PHOTOVOLTAIC DEVICE**
VERFAHREN ZUR HERSTELLUNG EINER FOTOVOLTAIKANORDNUNG, ZWISCHENHERSTELLUNGSPRODUKT UND FOTOVOLTAIKANORDNUNG
PROCÉDÉ DE FABRICATION D'UN DISPOSITIF PHOTOVOLTAÏQUE, PRODUIT DE FABRICATION INTERMÉDIAIRE ET DISPOSITIF PHOTOVOLTAÏQUE

(30) Priority: 02.10.2008 EP 08017371; 17.12.2008 EP 08021909
(43) Date of publication of application: 20.07.2011
(73) Proprietor: Swansea University, Swansea SA2 8PP (GB)
(72) Inventor: WIJDEKOP, Maarten, Chester CH4 8SY (GB); ENGLISH, Timothy, Harold, Sheffield S11 7JQ (GB)
(74) Representative: Myint, Julie Marie
(86) International application number: PCT/EP2009/007076
(87) International publication number: WO 2010/037554

(56) References cited:
- WO-A-2008/023848
- JP-A- 2006 295 035
- JP-A- 2007 194 569
- US-A1- 2002 050 289
- US-A1- 2005 274 412
- US-A1- 2006 289 056
- US-A1- 2007 194 311
- ITO S ET AL: "High-efficiency (7.2%) flexible dye-sensitized solar cells with Ti-metal substrate for nanocrystalline-TiO2 photoanode" CHEMICAL COMMUNICATIONS - CHEMCOM, ROYAL SOCIETY OF CHEMISTRY, GB, 14 August 2006 (2006-08-14), pages 4004-4006, XP002507808 ISSN: 1359-7345 [retrieved on 2006-08-14]
- R. V. Zakharchenko ET AL: "Nanostructured porous sol-gel materials for applications in solar cells engineering", physica status solidi (c), vol. 2, no. 9, 1 June 2005 (2005-06-01), pages 3308-3313, XP055208958, ISSN: 1610-1634, DOI: 10.1002/pssc.200461151
- ZAKHARCHENKO R ET AL: "Photovoltaic solar panel for a hybrid PV/thermal system", SOLAR ENERGY MATERIALS AND SOLAR CELLS, ELSEVIER SCIENCE PUBLISHERS, AMSTERDAM, NL, vol. 82, no. 1-2, 1 May 2004 (2004-05-01), pages 253-261, XP004503285, ISSN: 0927-0248, DOI: 10.1016/J.SOLMAT.2004.01.022

## Description

### FIELD OF THE INVENTION

The present invention relates to a method of manufacturing a photovoltaic device, to an intermediate manufacturing product and to a photovoltaic device as such.

### BACKGROUND OF THE INVENTION

Photovoltaic (PV) devices and manufacturing methods thereof are well known in the art. A photovoltaic device or solar cell converts light directly into electricity using the charge separating effect in junctions between semiconducting and light absorbing materials. In general a photovoltaic device comprises a carrier substrate, which is isolated from a back electrode. The back electrode is in electrical contact with an active PV absorber layer, which absorbs part of the incoming light and transforms it into electricity. On the topside, the PV absorber layer is in electrical contact with a transparent front electrode, which is usually covered with a transparent material that can be glass or a plastic film.

Photovoltaic devices can be classified, depending on the nature of the semiconductive material(s) used. The classical photovoltaic devices, available since the 1950's, are based on Crystalline Silicon technology, applied to glass substrates. More recently, thin film PV technologies such as Amorphous Silicon (a-Si), Copper Indium Gallium Selenide (CIGS) and Cadmium Telluride (CdTe) have been developed, which resulted in cheaper ways to manufacture solar cells.

Third generation or 'organic' PV devices that emerged in the 1990's use low-cost materials on flexible carrier substrates such as metal or plastic foil. Dye Sensitised solar Cells (DSC) fall into this category and are based on nanoparticulate Titania (TiO₂) impregnated with a light-absorbing dye. DSC is the most advanced technology of its kind. Other third generation PV technologies are based on organic or polymer-based semiconductors. Third generation PV manufacturing processes tend to be relatively simple and high speed.

DSC, also called Grätzel cells, are a technology based on low cost materials that can be applied to flexible carrier substrates such as a metal strip or a plastic foil in a continuous in-line production process. In a traditional batch manufacturing method for DSC, a transparent substrate like glass is provided with a transparent conductive layer in order to form a transparent front or 'window' electrode. A thin layer of a porous semiconductor, such as TiO₂, is then deposited onto this conductive layer. The porous semiconductor layer needs to be sintered at 350-550°C to achieve good electrical interconnectivity between the semiconductor particles, and between the semiconductor particles and the conductive layer of the cell. A suitable dye is absorbed into the porous semiconductor; and the carrier substrate with the conductive layer and dye-sensitised semiconductor forms the working electrode. An electrolyte is then deposited, which diffuses into the pores and forms a thin film on top of the working electrode.

The counter electrode can be based on a glass substrate or on a metal carrier substrate, and is produced separately. This part comprises an electrical conductor deposited onto the substrate and a molecular layer of a catalyst that could be platinum (Pt) or carbon (C) deposited onto the electrical conductor, which promotes transfer of electrons from the conductor to the electrolyte. The working electrode and counter electrode are assembled and sealed in order to prevent the electrolyte from leaking. For the cell to work, both the working electrode and the counter electrode need to be in physical contact with the electrolyte. Most research and development work on DSC involve batch-produced cells with a window electrode made of glass.

DSC may be interconnected into a module to generate a useful output voltage for which the conductive layer of the DSC must be interrupted. When metal carrier substrates are used an insulating layer is required to electrically isolate the metal. This insulating layer also functions to chemically separate the metal carrier substrate from the electrolyte, thus reducing reactive degradation.

A flexible dye sensitised solar cell comprising an insulating thin film disposed between a flexible conducting substrate and a conducting thin film is disclosed in US 2005/0274412 A1**.** The insulating film comprises an inorganic material such as SiOₓ, which is used to separate the electrolyte from the conducting substrate and improve the stability and energy conversion efficiency of the cell. In such a solar cell the electrically insulating layer comprises inorganic materials such as silica, which are traditionally applied by sputtering, i.e. materials are deposited under vacuum and at elevated temperatures. Such vacuum based processes typically limit the manufacture of dye sensitised solar cells according to US 2005/0274412 A1 to a batch process since they are difficult to implement into a continuous production line.

The electrically insulating layer should not break down at the maximum cell voltage. The actual voltage will be dependant on the number of cells that are connected in series, which in turn is determined by an inverter voltage. A typical DC voltage would be 24-50 V. Maintenance of insulation for voltages in this range can be demonstrated using commercially available pin-hole detection equipment such as that supplied by Elcometer.

Conductive layers are usually metallic or conductive oxides, which are also deposited using vacuum based technologies and may involve sputtering. It has appeared that sputtered inorganic layers like alumina, silica or conductive oxides can suffer from damage such as cracking or delamination from the metal carrier substrate during subsequent manufacturing steps. Additionally, the durability, flexibility and formability of a metal carrier substrate with inorganic layers may be reduced and are instead characterised by their inherent rigidity and brittleness. In addition, the relatively high cost of the raw materials, and the expensive operation of vacuum processing equipment, adds to the cost of the final product.

An object of the invention is to provide a manufacturing process of a photovoltaic device, so that the disadvantages mentioned above are reduced or eliminated. Another object of the invention is to provide such a manufacturing process that can be carried out on a continuous basis.

Another object of the invention is to provide the design of a photovoltaic device based on a metal carrier substrate.

A further object of the invention is to provide an intermediate product based on a metal carrier substrate, which is useful for manufacturing a photovoltaic device.

### SUMMARY OF THE INVENTION

According to the invention there is provided a method of manufacturing a photovoltaic device as defined in claim 1, as well as a photovoltaic device as defined in claim 9 and an intermediate product as claimed in claim 12.

The method according to the invention comprises a first step of providing a metal carrier substrate. A suitable example of a metal carrier substrate is a strip of steel. An organic electrically insulating layer having barrier properties is provided to prevent short-circuiting and diffusion of metal atoms from the metal carrier substrate into the electrolyte. In addition to its barrier and electrical insulating properties, the organic electrically insulating layer is resistant to the high temperatures used in further processing steps according to the invention. This layer is made from a material being resistant to temperatures in the range 200°C to 600°C, as will be explained herein below. The first electrically conductive layer is also made from a high temperature resistant material. The high temperature resistivity of these layers would allow the use of high temperature processing steps that are required to obtain the optimal properties of the semiconductive layer, e.g. sintering of TiO₂ particles to obtain a porous structure as in the case of a dye sensitised solar cell, or when using high temperature PVD/CVD processes such as CIGS, a-Si or CdTe deposition. The design according to the invention permits the use of a flexible transparent polymer film carrying a transparent conductive layer which functions as the 'window electrode' and is on top of the photovoltaic absorber layer. The transparent polymer film can be manufactured separately and then combined with the working electrode at a later stage in the production process, so that it is not subjected to the high temperatures when sintering the TiO₂ particles. An additional advantage is that a polymer film is easier to incorporate in a continuous reel-to-reel manufacturing process than the alternative, glass.

The invention enables continuous production of flexible DSC onto steel, where transparent, temperature sensitive, conductive polymer films are used as the 'window' electrode. A polymer film based window-electrode cannot be used as the working electrode, because high temperature (approx. 500°C) sintering of TiO₂ is required to achieve good electrical interconnectivity between the semiconductor particles, and between the semiconductor particles and the back contact of the cell, which would lead to thermal degradation of the polymer film. Sintering the TiO₂ onto the 'back' electrode instead of the 'front' or 'window' electrode results in a 'reverse' design of the photoactive layer with respect to the layout described above of a device obtained by the batch process. In a reverse design, the light enters through the counter-electrode, and finds its way through the electrolyte before being absorbed by the dye.

In this reverse design, the working electrode is carried by a metal carrier substrate; an organic electrically insulating layer is provided on this metal carrier, and an electrical conductor is provided on top of the organic electrically insulating layer, which will function as the back contact.

Here, the term "a high temperature resistant material" means a material that is able to resist the temperature used in subsequent manufacturing steps for the duration of such steps. As the organic electrically insulating layer and the first conductive layer do not have to show transparency, unlike the conductive layer on the front electrode, there is more freedom for selecting suitable high temperature resistant materials. Therefore, a slight deterioration of the layers on the metal carrier substrate upon exposure to high temperature is acceptable.

### DETAILED DESCRIPTION OF THE INVENTION

Strip metals such as steel and aluminium are very suitable as carrier substrates for flexible PV layers because both strip metals can be applied in a continuous in-line process. If the surface is to be divided into cells that are connected in series, the metal carrier substrate needs to be electrically insulated from the PV layers. According to the invention a material such as an organic coating for this purpose is used, which is resistant to the high temperatures of the subsequent processing steps associated with the deposition of additional PV layers. On top of this organic electrically insulating layer, a conductive layer needs to be deposited that functions as the back contact of the PV system.

This first conductive layer, also called the back contact, is located between the PV absorber and the organic electrically insulating layer on metal carrier substrate, and comprises a high temperature resistant material. This layer can, but does not necessarily have to be deposited by a vapour or sputter process. Examples not part of the invention comprise conductive oxides, such as fluorine doped tin oxide (SnO₂:F), indium doped tin oxide (ITO), zinc oxide (ZnO), titanium (Ti) and titanium nitride (TiN). Paints comprising interconnected metallic particles or inherently conductive is used in the invention as a first conductive layer. Roller coating, doctor-blading, printing and extrusions are examples of processes useful for applying paints and conductive polymers.

In view of the high temperatures required for obtaining electrically interconnected TiO₂ particles with a high surface area, DSC are certain to benefit from the invention. Other PV technologies that can be applied onto large surface areas in continuous processes include organic/polymer, CIGS or CdTe solar cells, which will also benefit from the invention.

The second conductive layer, also called the front contact, is located between the PV absorber layer and the transparent counter-electrode material, and may be made from the same materials as the first conductive layer, provided that the layer is transparent. Transparent films such as polyethylene terephtalate (PET), polyethylene naphtalate (PEN), polypropylene (PP), polycarbonate (PC) or polyimide foil carrying a transparent conductive oxide as mentioned above are used for a flexible counter electrode. If required, the conductivity of the transparent conductive oxide layer can be improved by providing current carriers and busbars. Normally, the transparent conductive laminate is fabricated separately and then connected and adhered to the PV absorber layer on the carrier substrate.

The method according to the invention is preferably carried out in a continuous in-line process, wherein the organic electrically insulating layer which is a high temperature resistant material and the first conductive layer are applied in sequence to the metal carrier substrate. The active photovoltaic layer is applied in the same process line, followed by in-line application of the transparent conductive film mentioned above.

The invention is also directed to an intermediate product for manufacturing a photovoltaic device as defined in claim 9 comprising a metal carrier substrate, preferably a metal strip, an organic electrically insulating layer and a first conductive layer on top of the organic electrically insulating layer. This intermediate product can be easily manufactured in a continuous in-line process using techniques as described hereinbefore. Optionally, the intermediate product can also include the PV absorber layer, in particular a porous semiconductive layer like TiO₂.

As the various application processes may require different circumstances and processing times, a separation of the whole process in a number of steps having more or less the same duration would add to the overall flexibility of the process.

The invention also relates to a photovoltaic device as claimed in claim 12, comprising a metal carrier substrate, an electrically insulating layer having barrier properties comprising a high temperature resistant material, that is an organic material deposited onto the metal carrier substrate, a first electrically conductive layer of a high temperature resistant material a PV absorber layer comprising a dye sensitised semiconductive material contacting the first electrically conductive layer and a second transparent electrically conductive layer in contact with the PV absorber layer.

The preferred embodiments disclosed herein above regarding the manufacturing method according to the invention are similarly applicable to the intermediate product and photovoltaic device according to the invention.

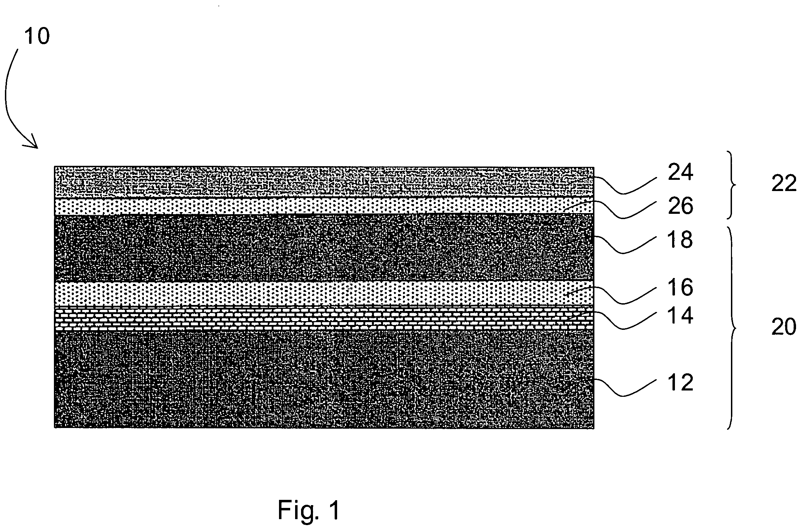

In figure 1 an embodiment of a photovoltaic device according to the invention is indicated in its entirety by reference numeral 10. The device 10 has a metal carrier substrate 12, which has been coated with an organic, electrically insulating coating layer 14 having barrier properties, as well as resistance to high temperatures. A back contact of the photovoltaic device 10 is formed by a conductive layer 16, which is a paint comprising conductive metallic particles. A PV absorber layer 18, which can possibly be dye-sensitized TiO₂, is in electrical contact with the back contact 16. Together these two layers form the working electrode. Subsequently, the semiconductive material may be subjected to a high temperature (200-600°C) process, such as the sintering of TiO₂ particles followed by absorption of a suitable dye to form the PV absorber layer 18;

Alternatively, the PV absorber layer 18 can be provided by PVD/CVD deposition of other inorganic systems such as CIGS, CdTe or a-Si. A suitable catalyst like Pt may have been applied to the back contact conductive layer 16.

The assembly 20 consisting of these functional layers is a semi finished product. Separately a transparent laminate 22 comprising a transparent polymer film 24, and a transparent conductor 26 has been manufactured. The assembly 20 and film 22 are put together, appropriately interconnected and then sealed together.

In the case of a DSC cell, a suitable electrolyte is deposited just before the sealing process takes place, and encapsulated between assembly 20 and laminate 22.

### SHORT DESCRIPTION OF THE DRAWINGS

Fig.1 shows the DSC product according to the invention.
Fig.2 shows Cyclic Voltammetry traces for temperature resistant polymers before and after heating at 500°C.

### EXPERIMENTAL

The insulating layer has multifunctional properties as it has to bond to the substrate and maintain flexibility and robustness. However, for application in a photovoltaic it must also display two important functions:
- electrical insulation between the PV cells and the metal carrier
- for DSC, prevent reactive degradation of the metal by the iodine/tri-iodide containing electrolyte; this property must be maintained even after exposure of the coating to the heat treatment needed for sintering the TiO₂ particles.

A requirement for the electrically insulating layer is that the coating should be not break down at the maximum cell voltage.

The electrolyte contains both tri-iodide ions and iodine molecules, both of which are capable of oxidising or corroding the steel carrier. Thus, the barrier properties of the electrically insulating layer should prevent reactive degradation and prevent the removal of the iodine components from the electrolyte, which would ultimately compromise the activity and efficiency of the DSC cell. A technique for measuring activity across the insulating layer is Cyclic Voltammetry, which measures the current flow per unit area using a potentiostat. A potentiostat is a control and measuring device that maintains the potential of the working electrode at a constant level with respect to the reference electrode in an electrolytic cell. It consists of an electric circuit which controls the potential across the cell by sensing changes in its resistance, varying accordingly the current supplied to the system: a higher resistance will result in a decreased current, while a lower resistance will result in an increased current, in order to keep the voltage constant.

The current flow that is measured with this method is an effective measure of consumption of the iodine components of the electrolyte, without which the cell would cease to function. For a typical millimolar tri-iodide concentration within the electrolyte it has been established that CV current densities should be equal to or below 0.15 nA/cm² to ensure a 25 year product lifetime for a DSC cell. When current densities flowing through the insulating layer are above this value, it can be shown that the concentration of iodide ions, which function as charge carriers in the electrolyte, will diminish to the extent that the DSC will cease to operate effectively before the end of its 25 year product lifetime. An example of such performance is shown for a silicon-bearing temperature resistant polymer. The following conditions were used to perform the CV experiment:
- Commercial Solartron type 1287 and 1280B potentiostats were used. A standard three electrode arrangement was employed with the material under test forming the working electrode and a Platinum electrode forming the counter electrode with a Ag/AgCl electrode in saturated KCI solution acting as reference.
- Scan rate 10 mV/s
- Scan Voltage 0 to 1 V, to -0.5 V, to 0 V.
- Test solution of 1M NaCl solution
- Cell area approximately 5 cm². This area was chosen for convenience, as tested samples were small and a 25mm internal diameter tube was used to define the cell walls with the sample under test forming the base of the test cell.

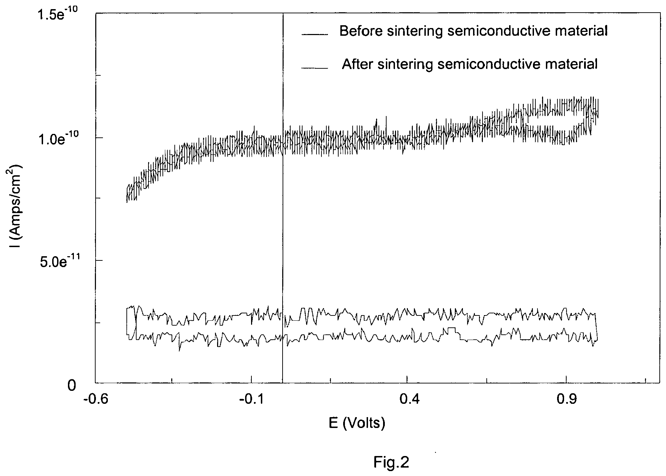

The CV trace in Figure 2 clearly shows current densities of approximately 0.1nA/cm² before heat treatment and lower current densities of approximately 0.02-0.03 nA/cm² after heat treatment at 500°C; from this we can derive that the tested silicon-bearing temperature resistant polymer is a suitable candidate to function as the organic insulating layer of a DSC cell on a steel carrier substrate.

Advantageously, the resistivity of the electrically insulating layer after the step of providing a photovoltaic absorber layer comprising a dye sensitised semiconductive material on the first electrically insulating layer results in a current density below 0.15 nA/cm², as measured by the CV experiment. Such a value will ensure that the active components within the electrolyte are not consumed during the lifetime of the said photovoltaic device..

A critical property of the first electrically conductive layer is its sheet resistance, which is a measure of electrical resistance of thin films that have a uniform thickness. Sheet resistance can be expressed in 'Ohms per square'; this value gives the resistance in Ohms of current passing from one side of a square region in the conductive thin film to the opposite side, regardless of the size of the square.

Advantageously, the sheet resistance of the first electrically conductive layer after the step of providing a photovoltaic absorber layer comprising a dye sensitised semiconductive material on the electrically conductive layer equal to or below 15 Ohms per square to minimise resistive losses within the cell. More preferably the sheet resistance value of the first electrically conductive layer after the heat treatment is equal to or lower than its original value.

The following materials are preferred when organic coatings are used to insulate DSC from metal carrier substrates;
- Polyimides / polyamides; these are applied with coating thicknesses of tens of microns and are routinely used for high temperature applications.
- Similarly Silicone-based paints, also applied in tens of microns and also able to withstand high temperatures
- Sol-gels, applied in thin layers (few microns), but shown to enhance the insulating properties when combined with polyimides/amides and silicone based paints.
- polyestersulfones (PES), normally used for applications such as car exhausts, have good resistance to chemicals and high temperatures.
- polyfluorinated polymers like (poly)tetrafluorethylenes (PTFE; ETFE); used for bakeware applications.

It has been shown that layers from these materials allow high-temperature processing, in particular, heat treatments for achieving a high efficiency between 200°C and 600°C, that are required for the deposition of thin film semiconductors like CIGS, CIS, CdTe and TiO₂ for DSC cells. The functionalisation of metal carrier substrates with organic layers offers increased flexibility and ease of manipulation/modification to obtain a cost effective intermediate product, possessing desirable properties for use in a PV device. These materials can be applied using techniques like roller coating, doctor-blading, spray coating, printing, extrusion and lamination.

The higher temperature limit of 600°C is based on the phase transition from anatase to rutile of TiO₂, whereas the lower temperature limit is based on the maximum processing temperatures of commodity polymers like PEN; if the processing temperatures of flexible PV technologies are below 200°C, they can be deposited directly on PEN and the 'reverse design' as used in the invention is not advantageous because the sunlight has to travel further to reach the PV absorber layer.

## Claims

1. A method of manufacturing a photovoltaic device (10), comprising the steps of:
• providing a metal carrier substrate (12),
• providing an organic electrically insulating layer (14) having barrier properties on said metal carrier substrate (12),
• providing a first electrically conductive layer (16) on the electrically insulating layer (14),
• providing a photovoltaic absorber layer (18) comprising a semiconductive material on the electrically conductive layer (16),
• providing a transparent second conductive layer (26) on the photovoltaic layer (18);
wherein at least the electrically insulating layer (14) and the first electrically conductive layer (16) comprise a material resistant to high temperature in the range of 200 degrees Celsius to 600 degrees Celsius, **characterised in that** the first electrically conductive layer (16) comprises paint, the paint comprising interconnected metallic particles or an inherently conductive polymer.

2. A method according to claim 1 , wherein the electrically insulating layer (14) has a resistivity that produces a current density equal to or below 0.15 nA/cm² during the Cyclic Voltammetry test before providing the PV absorber layer.

3. A method according to one of the preceding claims, wherein the first electrically conductive layer has a sheet resistance of equal to or below 15 Ohms per square before providing a PV absorber layer.

4. A method according to one of the preceding claims, wherein the resistivity of the electrically insulating layer after the step of providing the photovoltaic absorber layer (18) on the first electrically conductive layer (16) maintains a value equal to or below 0.15 nA/cm² when subjected to the CV test.

5. A method according to one of the preceding claims, wherein the sheet resistance of the first electrically conductive layer after the step of providing a photovoltaic absorber layer (18) on the electrically conductive layer (16) is maintained at a value equal to or below 15 Ohms per square.

6. A method according to one of the preceding claims, wherein the step of providing a photovoltaic absorber layer is carried out at a temperature in the range from about 200 degrees C to about 600 degrees C.

7. A method according to one of the preceding claims, wherein the step of providing a photovoltaic absorber layer (18) comprises depositing a nanoparticulate semiconductor material, which is subjected to a 350-550 degrees C sintering process to obtain a porous structure and good electrical connectivity between the particles, followed by the absorption of a light-absorbing dye into the interconnected porous semiconductor structure.

8. A method according to one of the preceding claims, wherein an assembly (20) of the metal carrier substrate (12), electrically insulating layer (14), first conductive layer (16) and photovoltaic absorber layer (18) is made, as well as a transparent film (22) comprising a transparent foil (24) carrying the transparent second conductive layer (26) and optionally a catalyst, followed by assembling the assembly (20) and film (22) together.

9. An intermediate product for manufacturing a photovoltaic device, comprising a metal carrier substrate (12), an electrically insulating layer (14) having barrier properties on said metal carrier substrate (12) and a first conductive layer (16) on top of the electrically insulating layer (14) wherein at least the electrically insulating layer is an organic material (14) and the electrically insulating layer and the first electrically conductive layer (16) comprise a material resistant to high temperature in the range 200 degrees Celsius to 600 degrees Celsius, **characterised in that** the first conductive layer (16) comprises paint, the paint comprising interconnected metallic particles or an inherently conductive polymer.

10. An intermediate product according to claim 9, furthermore comprising a photovoltaic absorber layer (18).

11. An intermediate product or photovoltaic device according to one of the preceding claims 9-10, wherein the photovoltaic absorber layer (18) comprises a semiconductor material sintered into a porous structure, which has been sensitized by a dye.

12. A photovoltaic device (10), comprising:
• a metal carrier substrate (12);
• an organic electrically insulating layer (14) having barrier properties comprising a material resistant to high temperature in the range of 200 degrees Celsius to 600 degrees Celsius on the metal carrier substrate (12);
• a first electrically conductive layer (16) of a material resistant to high temperature in the range of 200 degrees Celsius to 600 degrees Celsius and comprising a paint, the paint comprising interconnected metallic particles or an inherently conductive polymer;
• a photovoltaic absorber layer (18) comprising a semiconductive material contacting the first electrically conductive layer (16), a transparent second conductive layer (26) on the photovoltaic layer (18).

13. A photovoltaic device according to claim 12, further comprising a catalyst deposited on the second electrically conductive layer (26) that promotes transfer of electrons from the counter electrode to the charge carriers in the electrolyte.

## Patentansprüche

1. Verfahren zur Herstellung einer Fotovoltaikanordnung (10), umfassend die folgenden Schritte:
• Bereitstellen eines Metallträgersubstrats (12),
• Bereitstellen einer organischen elektrisch isolierenden Schicht (14), die Barriere-Eigenschaften aufweist, auf dem Metallträgersubstrat (12),
• Bereitstellen einer ersten elektrisch leitenden Schicht (16) auf der elektrisch isolierenden Schicht (14),
• Bereitstellen einer Fotovoltaik-Absorberschicht (18), die ein Halbleitermaterial umfasst, auf der elektrisch leitenden Schicht (16),
• Bereitstellen einer transparenten zweiten leitenden Schicht (26) auf der Photovoltaik-Schicht (18);
wobei zumindest die elektrisch isolierende Schicht (14) und die erste elektrisch leitende Schicht (16) ein Material umfassen, das beständig gegen hohe Temperaturen im Bereich von 200 Grad Celsius bis 600 Grad Celsius ist, **dadurch gekennzeichnet, dass** die erste elektrisch leitende Schicht (16) Farbe umfasst, wobei die Farbe untereinander verbundene Metallpartikel oder ein inhärent leitendes Polymer umfasst.

2. Verfahren nach Anspruch 1, wobei die elektrisch isolierende Schicht (14) einen spezifischen Widerstand aufweist, der während des Cyclovoltammetrie-Tests vor dem Bereitstellen der FV-Absorberschicht eine Stromdichte gleich oder unter 0,15 nA/cm² erzeugt.

3. Verfahren nach einem der vorhergehenden Ansprüche, wobei die erste elektrisch leitende Schicht vor dem Bereitstellen einer FV-Absorberschicht einen Schichtwiderstand gleich oder unter 15 Ohm pro Quadrat aufweist.

4. Verfahren nach einem der vorhergehenden Ansprüche, wobei der spezifische Widerstand der elektrisch isolierenden Schicht nach dem Schritt des Bereitstellens der Fotovoltaik-Absorberschicht (18) auf der ersten elektrisch leitenden Schicht (16) einen Wert gleich oder unter 0,15 nA/cm² beibehält, wenn er dem CV-Test unterzogen wird.

5. Verfahren nach einem der vorhergehenden Ansprüche, wobei der Schichtwiderstand der ersten elektrisch leitenden Schicht nach dem Schritt des Bereitstellens einer Fotovoltaik-Absorberschicht (18) auf der elektrisch leitenden Schicht (16) bei einem Wert gleich oder unter 15 Ohm pro Quadrat gehalten wird.

6. Verfahren nach einem der vorhergehenden Ansprüche, wobei der Schritt des Bereitstellens einer Fotovoltaik-Absorberschicht bei einer Temperatur im Bereich von etwa 200 Grad C bis etwa 600 Grad C durchgeführt wird.

7. Verfahren nach einem der vorhergehenden Ansprüche, wobei der Schritt des Bereitstellens einer Fotovoltaik-Absorberschicht (18) das Auftragen eines Nanopartikel-Halbleiter-Materials, das einem Sinterprozess bei 350-550 Grad C unterzogen wird, um eine poröse Struktur und eine gute elektrische Verbindung zwischen den Partikeln zu erhalten, gefolgt vom Absorbieren eines lichtabsorbierenden Farbstoffs in die untereinander verbundene poröse Halbleiterstruktur umfasst.

8. Verfahren nach einem der vorhergehenden Ansprüche, wobei eine Baugruppe (20) des Metallträgersubstrats (12), der elektrisch isolierenden Schicht (14), der ersten leitenden Schicht (16) und der Fotovoltaik-Absorberschicht (18) hergestellt wird, sowie ein transparenter Film (22), der eine transparente Folie (24), welche die transparente zweite leitende Schicht (26) trägt, und optional einen Katalysator umfasst, und anschließend die Baugruppe (20) und der Film (22) zusammengebaut werden.

9. Zwischenprodukt zur Herstellung einer Fotovoltaikanordnung, das ein Metallträgersubstrat (12), eine elektrisch isolierende Schicht (14), die Barriere-Eigenschaften aufweist, auf dem Metallträgersubstrat (12) und eine erste leitende Schicht (16) oben auf der elektrisch isolierenden Schicht (14) umfasst, wobei zumindest die elektrisch isolierende Schicht aus einem organischen Material (14) besteht und die elektrisch isolierende Schicht und die erste elektrisch leitende Schicht (16) ein Material umfassen, das beständig gegen hohe Temperaturen im Bereich von 200 Grad Celsius bis 600 Grad Celsius ist, **dadurch gekennzeichnet, dass** die erste leitende Schicht (16) Farbe umfasst, wobei die Farbe untereinander verbundene Metallpartikel oder ein inhärent leitendes Polymer umfasst.

10. Zwischenprodukt nach Anspruch 9, ferner umfassend eine Fotovoltaik-Absorberschicht (18).

11. Zwischenprodukt oder Fotovoltaikanordnung nach einem der vorhergehenden Ansprüche 9-10, wobei die Fotovoltaik-Absorberschicht (18) ein Halbleitermaterial umfasst, das in eine poröse Struktur gesintert ist, die durch einen Farbstoff sensibilisiert wurde.

12. Fotovoltaikanordnung (10), umfassend:
• ein Metallträgersubstrat (12);
• eine organische elektrisch isolierende Schicht (14), die Barriere-Eigenschaften aufweist und ein Material umfasst, das beständig gegen hohe Temperaturen im Bereich von 200 Grad Celsius bis 600 Grad Celsius ist, auf dem Metallträgersubstrat (12);
• eine erste elektrisch leitende Schicht (16) aus einem Material, das beständig gegen hohe Temperaturen im Bereich von 200 Grad Celsius bis 600 Grad Celsius ist, die eine Farbe umfasst, wobei die Farbe untereinander verbundene Metallpartikel oder ein inhärent leitendes Polymer umfasst;
• eine Fotovoltaik-Absorberschicht (18), die ein Halbleitermaterial umfasst und die erste elektrisch leitende Schicht (16) berührt; eine transparente zweite leitende Schicht (26) auf der Fotovoltaikschicht (18).

13. Fotovoltaikanordnung nach Anspruch 12, ferner umfassend einen auf die zweite elektrisch leitende Schicht (26) aufgetragenen Katalysator, der einen Elektronentransfer von der Gegenelektrode zu den Ladungsträgern im Elektrolyt fördert.

## Revendications

1. Procédé de fabrication d'un dispositif photovoltaïque (10), comprenant les étapes consistant à :
• fournir un substrat support métalliques (12),
• fournir une couche électriquement isolante organique (14) ayant des propriétés barrières sur ledit substrat support métallique (12),
• fournir une première couche électriquement conductrice (16) sur la couche électriquement isolante (14),
• fournir une couche d'absorbeur photovoltaïque (18) comprenant un matériau semi-conducteur sur la couche électriquement conductrice (16),
• fournir une seconde couche conductrice transparente (26) sur la couche photovoltaïque (18) ;
dans lequel au moins la couche électriquement isolante (14) et la première couche électriquement conductrice (16) comprennent un matériau résistant à une température élevée dans la plage de 200 degrés Celsius à 600 degrés Celsius, **caractérisé en ce que** la première couche électriquement conductrice (16) comprend une peinture, la peinture comprenant des particules métalliques interconnectées ou un polymère intrinsèquement conducteur.

2. Procédé selon la revendication 1, dans lequel la couche électriquement isolante (14) a une résistivité qui produit une densité de courant égale ou inférieure à 0,15 nA/cm² au cours du test de voltampérométrie cyclique avant de fournir la couche d'absorbeur photovoltaïque.

3. Procédé selon l'une des revendications précédentes, dans lequel la première couche électriquement conductrice a une résistance à couche égale ou inférieure à 15 ohms par carré avant de fournir une couche d'absorbeur photovoltaïque.

4. Procédé selon l'une des revendications précédentes, dans lequel la résistivité de la couche électriquement isolante après l'étape de fourniture de la couche d'absorbeur photovoltaïque (18) sur la première couche électriquement conductrice (16) maintient une valeur égale ou inférieure à 0,15 nA/cm² lorsqu'elle est soumise au test de voltampérométrie cyclique.

5. Procédé selon l'une des revendications précédentes, dans lequel la résistance à couche de la première couche électriquement conductrice après l'étape de fourniture d'une couche d'absorbeur photovoltaïque (18) sur la couche électriquement conductrice (16) est maintenue à une valeur égale ou inférieure à 15 ohms par carré.

6. Procédé selon l'une des revendications précédentes, dans lequel l'étape de fourniture d'une couche d'absorbeur photovoltaïque est réalisée à une température dans la plage d'environ 200 degrés C à environ 600 degrés C.

7. Procédé selon l'une des revendications précédentes, dans lequel l'étape de fourniture d'une couche d'absorbeur photovoltaïque (18) comprend le dépôt d'un matériau semi-conducteur à nanoparticules, qui est soumis à un processus de frittage à 350-550 degrés C pour obtenir une structure poreuse et une bonne connectivité électrique entre les particules, suivi par l'absorption d'un colorant absorbant la lumière dans la structure semi-conductrice poreuse interconnectée.

8. Procédé selon l'une des revendications précédentes, dans lequel un ensemble (20) du substrat support métallique (12), de la couche électriquement isolante (14), de la première couche conductrice (16) et de la couche d'absorbeur photovoltaïque (18) est réalisé, ainsi qu'un film transparent (22) comprenant une feuille transparente (24) supportant la seconde couche conductrice transparente (26) et facultativement un catalyseur, suivi par l'assemblage de l'ensemble (20) et du film (22) ensemble.

9. Produit intermédiaire pour fabriquer un dispositif photovoltaïque, comprenant un substrat support métallique (12), une couche électriquement isolante (14) ayant des propriétés barrières sur ledit substrat support métallique (12) et une première couche conductrice (16) par-dessus la couche électriquement isolante (14), dans lequel au moins la couche électriquement isolante est un matériau organique (14) et la couche électriquement isolante et la première couche électriquement conductrice (16) comprennent un matériau résistant à une température élevée dans la plage de 200 degrés Celsius à 600 degrés Celsius, **caractérisé en ce que** la première couche conductrice (16) comprend une peinture, la peinture comprenant des particules métalliques interconnectées ou un polymère intrinsèquement conducteur.

10. Produit intermédiaire selon la revendication 9, comprenant en outre une couche d'absorbeur photovoltaïque (18).

11. Produit intermédiaire ou dispositif photovoltaïque selon l'une des revendications 9-10, dans lequel la couche d'absorbeur photovoltaïque (18) comprend un matériau semi-conducteur fritté en une structure poreuse, qui a été sensibilisée par un colorant.

12. Dispositif photovoltaïque (10), comprenant :
• un substrat support métallique (12) ;
• une couche électriquement isolante organique (14) ayant des propriétés barrières comprenant un matériau résistant à une température élevée dans la plage de 200 degrés Celsius à 600 degrés Celsius sur le substrat support métallique (12) ;
• une première couche électriquement conductrice (16) d'un matériau résistant à une température élevée dans la plage de 200 degrés Celsius à 600 degrés Celsius et comprenant une peinture, la peinture comprenant des particules métalliques interconnectées ou un polymère intrinsèquement conducteur ;
• une couche d'absorbeur photovoltaïque (18) comprenant un matériau semi-conducteur entrant en contact avec la première couche électriquement conductrice (16), une seconde couche conductrice transparente (26) sur la couche photovoltaïque (18).

13. Dispositif photovoltaïque selon la revendication 12, comprenant en outre un catalyseur déposé sur la seconde couche électriquement conductrice (26) qui facilite le transfert d'électrons de la contre-électrode aux supports de charge dans l'électrolyte.
